Europäisches Patentamt

European Patent Office

Office européen des brevets

(19)

(11) **EP 0 634 502 B1**

(12) **FASCICULE DE BREVET EUROPEEN**

(45) Date de publication et mention
de la délivrance du brevet:
**29.12.1997   Bulletin 1997/52**

(51) Int Cl.⁶: **C23C 18/18**, C04B 41/51

(21) Numéro de dépôt: **94870120.6**

(22) Date de dépôt: **13.07.1994**

(54) **Procédé de production d'une couche métallique fortement adhérente sur de l'alumine frittée et produit métallisé ainsi obtenu**

Verfahren zur Herstellung einer stark haftenden Metallschicht auf gesintertes Aluminiumoxid, sowie auf diese Weise hergestelltes metallisiertes Produkt

Process for producing a strongly adhering metallic layer on sintered alumina and metallised product thus obtained

(84) Etats contractants désignés:
**BE CH DE ES FR GB IT LI NL**

(30) Priorité: **13.07.1993  BE 9300723**

(43) Date de publication de la demande:
**18.01.1995   Bulletin 1995/03**

(73) Titulaire: **Laude, Lucien Diégo**
**F-59330 Hautmont (FR)**

(72) Inventeur: **Laude, Lucien Diégo**
**F-59330 Hautmont (FR)**

(74) Mandataire: **Schmitz, Yvon et al**
**GEVERS Patents,**
**Brussels Airport Business Park,**
**Holidaystraat 5**
**1831 Diegem (BE)**

(56) Documents cités:
**EP-A- 0 377 867**

• **ADVANCED MATERIALS FOR OPTICS AND ELECTRONICS, vol.2, no.4, Juillet 1993, GB pages 183 - 189 SHAFEEV 'laser activation and metallisation of oxide ceramics'**

**Description**

La présente invention est relative à un procédé à trois étapes pour la production d'une couche métallique fortement adhérente sur un substrat d'alumine frittée. Le procédé qui est décrit dans le cadre de la présente invention est spécialement conçu pour l'adhérence la plus élevée d'un métal sur un substrat d'alumine frittée et permet effectivement d'obtenir une telle adhérence.

Les matériaux diélectriques durs, comme les matériaux céramiques, offrent d'une manière générale peu de compatibilité avec d'autres matériaux, comme les métaux. Les liaisons interatomiques (ioniques) qui sont présentes dans les matériaux diélectriques sont suffisamment fortes pour empêcher à la fois : une rupture aisée (ou toute séparation d'atomes) via des moyens thermiques, et une réaction chimique en substances habituellement agressives comme des acides. Comme une conséquence parmi d'autres, réaliser la liaison de ces matériaux passifs à des métaux est une tâche difficile pour laquelle seuls des procédés imparfaits ont été développés jusqu'à présent.

De plus, et à côté du caractère commun d'ionicité à tous ces matériaux diélectriques durs, chacun de ceux-ci est fortement spécifique en ce qui concerne sa composition et son organisation. Par conséquent, chacun des procédés de métallisation qui a été développé pour des matériaux céramiques jusqu'à présent reste spécifique à un matériau céramique donné, et même à une forme de production particulière de ce matériau céramique, en particulier à cause du rôle des impuretés et autres défauts dans la diffusion d'un métal dans ce matériau céramique. Ceci est le cas des matériaux céramiques frittés. Ces derniers matériaux peuvent contenir des grains d'une composition donnée, par exemple $Al_2O_3$ (ou alumine), qui sont maintenus ensemble via un ciment. Ce ciment est généralement formé par recuit à haute température d'un mélange comprimé de ces grains avec une proportion relativement faible (par exemple de 0,02 à 12 %) de particules de silicates et/ou d'autres oxydes. Au cours du procédé de recuit, ceux-ci sont fondus et forment, après solidification, un ciment amorphe qui relie entre eux les grains majoritaires et joue un rôle essentiel en maintenant en une structure rigide toute la matière à présent frittée. Les propriétés physiques (en particulier mécaniques et thermiques) de la matière frittée dépendent fortement de ce ciment et de la manière suivant laquelle il a été formé, c'est-à-dire de sa composition initiale ainsi que de la pression, de la température et de la durée du processus de frittage.

La spécification majeure de toute liaison métal/matériau céramique réside dans l'évaluation de l'adhérence du métal au matériau céramique, c'est-à-dire la résistance du couplage mécanique entre la surface d'une telle matière frittée et une couche métallique qui est déposée sur celle-ci. La plupart des procédés connus qui ont été développés jusqu'à présent pour la métallisation de la surface d'une alumine frittée découlent de l'ensemencement d'une telle surface avec des atomes ou ions métalliques, suivi d'un traitement autocatalytique et, quelquefois, d'un dépôt électrolytique de métal. L'ensemencement de métal peut être réalisé, par exemple, par décomposition de molécules organométalliques au voisinage de la surface métallisée ou sur celle-ci. Dans ces procédés, on réalise une préparation de la surface avant la métallisation, qui a principalement pour but (i) de nettoyer la surface des molécules indésirables, (ii) d'augmenter la surface effective du matériau céramique utilisé comme substrat en le rendant rugueux par dépolissage et (iii) de créer des défauts sur cette surface qui pourraient être actifs lors de l'immersion du substrat dans la solution de liquide autocatalytique et attirer les ions métalliques du bain. En tant que telle, la préparation est longue, coûteuse et seulement approximative en ce qui concerne son efficacité.

Une autre manière d'ensemencer la surface d'un matériau céramique consiste d'abord à préparer la surface tel que ci-dessus (nettoyage, dépolissage et production de défauts), et ensuite à appliquer sur la surface une peinture contenant du molybdène atomique (Mo) et de l'oxyde de manganèse ($MnO_2$). Ces derniers sont apportés à la surface pour occuper des défauts superficiels spécifiques comme des lacunes d'atomes qui sont occasionnellement présentes le long de fissures ou d'autres défauts microscopiques de la surface. Sur ces sites, des atomes de molybdène (Mo) ou de manganèse (Mn) peuvent éventuellement se substituer à des atomes d'aluminium (Al) et sont ensuite fortement couplés au réseau d'alumine via des liaisons ioniques. Lors de l'immersion dans un bain autocatalytique, les ions métalliques provenant du bain peuvent être attirés par ces atomes de Mo ou Mn, en provoquant ainsi un dépôt métallique "décorant" les sites ensemencés de métal sur la surface de l'alumine frittée. Bien qu'une métallisation efficace soit obtenue de cette manière, la distribution effective de ces sites ensemencés est totalement hors de contrôle puisqu'elle dépend uniquement de la présence de défauts superficiels préexistants de divers types qui sont distribués au hasard à la surface de l'alumine frittée. Des incertitudes quant à la nature, la concentration et la distribution de ces divers défauts peuvent conduire à d'importantes inhomo-généités à la frontière entre l'alumine et la couche métallique, et par conséquent à une liaison métal/alumine non fiable. Par ailleurs, la métallisation par de telles méthodes de surfaces à géométrie très précise ou peu étendues est rendue très difficile, voire impossible, à cause des techniques approximatives qui sont utilisée pour préparer la surface et ensuite appliquer la peinture contenant du métal.

Dans toutes les diverses formes de cette préparation de surface, les questions d'adhérence et d'amélioration de l'adhérence sont abordées uniquement via la possibilité de modifier l'aspect physique de la surface à métalliser, en particulier en augmentant la surface effective du matériau céramique en contact avec le bain.

Complémentairement et quel que soit l'aspect de la surface avant la métallisation ou la technique utilisée pour amener les atomes métalliques sur la surface, l'adhérence peut également être améliorée a posteriori par un traitement thermique de la pièce métallisée. En agissant de la sorte, les atomes métalliques qui sont présents à l'interface métal/matériau céramique sont amenés à migrer à l'intérieur du matériau céramique en diffusant le long des joints de grains ou à l'intérieur du ciment jusqu'à une certaine distance de la surface de la pièce. Cette migration dépend des facteurs suivants : i) la taille des grains et la distribution de taille des grains, ii) le type de ciment, iii) les paramètres du processus de diffusion en tant que tel (température, temps et éventuelles distributions en gradient de ceux-ci), iv) le type d'atome métallique et v) la nature du couplage entre ces atomes métalliques et les atomes hôtes (alumine et ciment).

Les points iv) et v) ci-dessus jouent un rôle primordial dans l'évaluation de la qualité de la liaison métal/ matériau céramique. Du fait du choix des atomes métalliques qui sont amenés à la surface, des structures fortement liées associant ces atomes métalliques et les atomes d'aluminium et d'oxygène de l'alumine peuvent également être formées à la surface de l'alumine et jusqu'à 1 ou 2 nanomètres à l'intérieur de celle-ci. C'est par exemple le cas lorsque l'on intercale une mince feuille de titane (Ti) entre deux pièces d'alumine qui doivent être fixées ensemble. En pressant, à haute température et sous atmosphère inerte contrôlée, ces deux pièces de part et d'autre de la feuille de titane, des atomes de Ti sont amenés à se substituer à des atomes de Al à la surface de l'alumine, formant ainsi un composé tri-atomique très stable, de type ionique. Ce type de composé possède des propriétés intermédiaires entre celles du métal et celles de l'alumine. Il constitue donc le matériau interfacial le mieux adapté entre l'alumine et toute couche métallique épaisse. Cependant, sa présence se trouve ici limitée au voisinage immédiat de l'interface métal/alumine frittée. Son efficacité en tant qu'agent de liaison entre ces deux matériaux se trouve ainsi très fortement atténuée. Par ailleurs, la méthode décrite dans cet exemple ne peut être utilisée que pour "souder" ensemble deux pièces d'alumines. Elle n'est pas utilisable pour la métallisation directe de pièces isolées d'alumine, a fortiori lorsque les surfaces à métalliser sont très spécifiques.

Deux autres caractéristiques d'adhérence sont également importantes : la profondeur de pénétration des atomes métalliques et l'homogénéité (plane) de la distribution de métal résultante par rapport à la surface du matériau céramique. Du fait de la grande diversité des facteurs susmentionnés influençant la migration des atomes, une incertitude réside dans la prédiction de la pénétration et de l'homogénéité. De plus, et d'une manière plus importante, dans un tel processus de diffusion activé thermiquement, bien que la température appliquée au couple métal/matériau céramique soit suffisamment élevée pour faire fondre éventuellement la couche métallique (par exemple 1100°C), elle reste trop basse pour modifier la cohésion de la matière hôte (céramique) qui fond habituellement à des températures sensiblement supérieures (par exemple d'environ 2000°C pour l'alumine frittée). Par suite, la cristallinité de celle-ci reste inchangée au cours du procédé de diffusion et les atomes métalliques ne peuvent que glisser sur les joints de grains d'alumine au cours de leur diffusion. L'énergie de couplage entre ces atomes métalliques et le réseau d'alumine est alors limitée à des valeurs de l'ordre de 0,2-0,4 eV. Ceci signifie que, lors de tout traitement thermique additionnel, les mêmes atomes métalliques seraient amenés à migrer encore plus profondément à l'intérieur du matériau céramique, en dégarnissant ainsi sa région superficielle et en affaiblissant la liaison globale métal/matériau céramique. Le vieillissement de cette liaison qui en résulte est un inconvénient majeur de tous les processus de diffusion assistés thermiquement qui sont habituellement utilisés pour améliorer l'adhérence de métal sur de l'alumine fritté. Les buts de la présente invention sont précisément i) de prévoir une amélioration sensible de l'adhérence du métal sur l'alumine frittée et ii) d'atteindre la stabilité la plus élevée pour la liaison résultante entre l'alumine frittée et le métal.

Suivant la présente invention, l'amélioration de la résistance de liaison entre le métal et l'alumine frittée est obtenue en trois étapes, qui consistent successivement :

a) à irradier la surface de la pièce d'alumine frittée avec le faisceau de lumière UV émis par une source laser excimère qui travaille dans un régime pulsé;
b) à immerger la pièce irradiée dans une solution autocatalytique contenant des ions du métal à déposer uniquement sur les zones irradiées de la pièce;
c) à chauffer la pièce métallisée à haute température, soit par brasage soit par recuit sous une atmosphère de gaz inerte contrôlée.

Les deux premières étapes concernent un procédé de métallisation de matériaux céramiques qui a été décrit dans la demande de brevet EP n° 0 501 095.

Comme décrit dans la demande de brevet EP ci-dessus, la première étape est destinée à produire la fusion de la surface d'alumine frittée. Ceci est obtenu sous l'action d'un faisceau laser excimère dont la densité d'énergie à l'impact sur la pièce excède une valeur seuil donnée, par exemple 0,8 J/cm$^2$. Cette dernière valeur peut varier en fonction des caractéristiques (structure des grains, nature du ciment) de l'alumine frittée. Au cours de l'irridiation qui dure entre 20 et 30 nsec, la température atteinte par la pièce irradiée est supérieure à 2000°C. Celle-ci se dilate et fond très rapidement superficiellement. Par suite, la structure granulaire présente à sa surface disparait. Le matériau fondu est alors constitué d'un mélange de quasi-molécules di-atomiques (AlO) et d'atomes d'oxygène suivant la formule :

$$Al_2O_3 \rightarrow 2\,(AlO) + 1/2\,O_2$$

A cause de l'énergie cinétique acquise dans l'état fondu par les quasi-molécules AlO et les atomes d'oxygène, deux phénomènes se produisent alors :

i) l'alumine se vaporise suivant deux voies parallèles mais inégales : d'une part, les molécules AlO quittent la surface du matériau fondu pour former une phase gazeuse (AlO est un composé volatile), et d'autre part, certains des atomes d'oxygène libérés par l'émission de molécules AlO se recombinent entre eux pour former des molécules d'oxygène ($O_2$) qui quittent à leur tour la surface pour former une phase gazeuse. Cette deuxième voie est cependant 4 fois moins efficace que la première puisqu'une seule molécule d'oxygène est émise pour quatre molécules de monoxyde d'aluminium AlO : le matériau perd lors de la vaporisation deux fois plus d'aluminium que d'oxygène. La vaporisation de l'alumine conduit donc systématiquement à son apauvrissement en aluminium et à son enrichissement en oxygène;
ii) les atomes d'oxygène qui ne réussissent pas à se recombiner migrent alors hors de la zone fondue de l'alumine, en se déplaçant de sa surface vers son volume qui est plus froid, en accord avec les lois classiques de la diffusion. Ce deuxième phénomène préserve ainsi l'enrichissement en oxygène atomique de l'alumine solide qui reste à une température inférieure au point de fusion.

Lors de l'interruption de l'irradiation laser, la couche liquide superficielle refroidit et se solidifie. C'est cette partie du matériau qui se trouve alors être la plus froide, par rapport au volume de la pièce. Les atomes d'oxygène qui étaient en excès loin de cette surface (suite à l'enrichissement ci-dessus) migrent alors de nouveau et retournent vers la surface. Ils s'intégrent alors dans des grains d'alumine reconstitués lors de la solicification et qui ont une taille comprise entre 5 et 10 micromètres. La structure cristalline de ces grains d'alumine superficiels est alors identifiée, par diffraction de rayons X en incidence rasante, comme comprenant :

i) à la surface des grains et jusqu'à 20 nanomètres en profondeur, uniquement la phase γ de l'alumine, sans aucune phase amorphe ou vitreuse;
ii) entre 20 et 800 nanomètres comptés à partir de la surface de ces grains, la phase α fortement texturée de l'alumine;
iii) au-delà de 800 nanomètres de la surface des grains, la phase α non-texturée de l'alumine.

La phase γ de l'alumine peut être décrite comme étant une spinelle riche en lacunes cationiques dans laquelle un site d'aluminium sur trois serait vide. La composition chimique correspondante ($Al_4O_9$) peut aussi être associée au réseau de la phase α enrichi d'un atome d'oxygène pour chaque paire d'atomes d'oxygène suivant l'équation :

$$2\,Al_2O_3 + 3/2\,O_2 \rightarrow Al_4O_9.$$

Le mécanisme d'enrichissement en oxygène de l'alumine décrit plus haut (et qui fait suite à la fusion de l'alumine, puis à sa vaporisation sélective en AlO) pourvoit très exactement à cet enrichissement par l'équation :

$$3\,Al_2O_3 \rightarrow 6\,AlO + 3/2\,O_2.$$

La structure en spinelle insaturée de la phase γ constitue aussi un réseau "ouvert" métastable dans lequel le transport électronique serait en particulier favorisé comme dans un semiconducteur de type n.

De plus, chaque lacune cationique dans ce réseau "ouvert" représente un site attractif pour tout cation provenant par exemple d'une solution autocatalytique. Dans le procédé, l'ion métallique est amené à occuper un site cationique. Il est alors relié aux atomes d'oxygène voisins via des liaisons ioniques fortes. La force de cette liaison ionique est de l'ordre de 7 eV comparativement à l'énergie de couplage (0,2 à 0,4 eV) entre une surface et des atomes métalliques absorbés non-réactivement.

Puisque la phase γ est la seule présente à la surface de l'alumine frittée après irradiation par un faisceau laser excimère au-delà d'une densité d'énergie seuil, la sensibilité superficielle de l'alumine ainsi irradiée au bain autocatalytique peut être entièrement attribuée à cette phase γ. Cette sensibilité est aussi la plus élevée qui puisse être obtenue à partir de la surface de toute alumine. En effet, i) la distribution des lacunes cationiques qui est présente dans la phase γ est la plus élevée possible compte tenu des valences de l'aluminium et de l'oxygène, respectivement; ii) cette distribution est périodique dans la phase γ. En conséquence, l'interface entre l'alumine irradiée suivant les caractéristiques précitées et la couche métallique qui y est déposée par autocatalyse est homogène.

Ces caractéristiques de l'interface métal/alumine (c'est-à-dire une liaison ionique et une homogénéité), telle qu'obtenue via les deux premières étapes du procédé décrit conformément à l'invention, assurent les conditions nécessaires pour un contact optimal entre la matière hôte et la couche métallique. Toutefois, elles ne sont pas suffisantes pour obtenir l'adhérence la plus élevée qui est requise dans un grand nombre d'applications recherchées. Pour améliorer davantage la résistance de liaison entre le métal et l'alumine frittée, une troisième (et dernière) étape dans le procédé est requise. Dans cette dernière étape, les atomes métalliques, qui sont d'abord déposés par plaquage autocatalytique de la surface d'alumine irradiée au faisceau laser, sont amenés à diffuser à l'intérieur de la phase γ d'alumine pour occuper tous les sites lacunaires disponibles. Ceci est obtenu en chauffant à température élevée l'alumine métallisée d'une manière telle que les atomes métalliques diffusent à travers l'interface métal/matériau céramique. Comme mentionné ci-dessus, la phase γ est présente sur toute la surface des grains d'alumine qui se situent à l'intérieur du volume superficiel du substrat d'alumine, y compris donc les aires de ces grains qui ne sont pas orientées vers la surface extérieure du substrat d'alumine frittée. La diffusion d'atomes métalliques forcée conduit à l'occupation totale de tous les sites lacunaires cationiques dans les limites des grains d'alumine superficiels. Le produit final de cette diffusion est la synthèse d'une structure de spinelle à haute densité, saturée ($Al_4M_2O_9$), qui contient de l'aluminium, de l'oxygène et des atomes métalliques de diffusion (M). Ce processus de synthèse correspond à une substitution effective d'un tiers des atomes d'aluminium dans l'$Al_2O_3$ de départ, substitution qui est toutefois accompagnée d'une réduction de symétrie importante de la matière résultante comparativement à celle de la phase α d'alumine. Ce composé ternaire ionique forme ainsi une matière intercalée, continue, dense entre l'alumine et le métal plaqué. Les propriétés mécaniques de la nouvelle matière intercalée sont intermédiaires entre celles du métal et de l'alumine, en assurant ainsi la meilleure adhérence entre les matières couplées avec :

- une liaison ionique interatomique,
- une structure de spinelle saturée ternaire comme matière intercalée entre le métal et l'alumine,
- une homogénéité totale (c'est-à-dire une continuité) de l'interface entre le métal et l'alumine,
- une stabilité morphologique de l'interface vis-à-vis des conditions d'usure les plus sévères.

La présence du composé ternaire intercalé n'est pas limitée au voisinage immédiat (1 ou 2 nanomètres) de la surface d'alumine, mais s'étend plutôt plus profondément (20 nanomètres) à l'intérieur du volume des grains superficiels. Il peut également occuper des parties aussi distantes que sur la surface arrière de ces grains en surface, en fixant ainsi la couche métallique sur un volume étendu de la pièce d'alumine.

Les atomes métalliques qui peuvent occuper les sites vides (Al) de la phase γ et qui forment des liaisons fortes (covalentes ou ioniques) avec leurs atomes voisins sans induire de contraintes mécaniques dans le réseau atomique auront un rayon covalent $R_c$ identique ou très proche de celui de l'aluminium à $R_c = 0,118$ nanomètres (nm). Les meilleurs métaux possibles qui tombent dans cette catégorie sont : le chrome (0,118 nm), le manganèse (0,117 nm), le fer (0,117 nm), le cobalt (0,116 nm), le nickel (0,115 nm), le cuivre (0,117 nm), l'arsenic (0,120 nm) et le sélénium (0,116 nm).

Certains de ces métaux (comme le nickel et le cuivre) peuvent être déposés par plaquage autocatalytique en utilisant des solutions connues de l'art. D'autres métaux pourraient également occuper les sites vacants de la phase γ, toutefois avec certaines contraintes résiduelles. Ce sont le lithium (0,123 nm), le vanadium (0,122 nm), le zinc (0,125 nm), le germanium (0,122 nm), le bromium (0,114 nm), le ruthénium (0,125 nm), le rhodium (0,125 nm), le tellure (0,126 nm), l'iridium (0,127 nm) et le palladium (0,128 nm).

On donne ci-après un exemple non limitatif illustrant le procédé de métallisation de la présente invention.

## Exemple

Une plaque d'alumine frittée (épaisseur égale à 0,6 mm), contenant des grains d'alumine ayant des dimensions comprises entre 1 et 2 micromètres et présentant une pureté globale de 99,6 %, est d'abord irradiée avec une série de 10 impulsions successives émises par un faisceau laser excimère émettant à une longueur d'onde de 248 nm, à une densité d'énergie sur la surface d'alumine égale à 0,485 mJ/cm². Après irradiation, la plaque d'alumine est immergée pendant 45 minutes dans une solution de plaquage au cuivre autocatalytique standard maintenue à 30°C et une couche de cuivre d'une épaisseur de 3 micromètres est produite sur la partie irradiée de la plaque. Un recuit de la plaque métallisée est alors réalisé par chauffage pendant 10 minutes de la plaque dans un four maintenu à 300°C. L'adhérence de la couche métallique à la pièce d'alumine est examinée par un essai de traction dans lequel un fin fil de cuivre est soudé sur la couche métallique via une soudure à basse température. Lors d'une traction, la force appliquée pour séparer le fil de l'alumine métallisée est suffisante pour briser la plaque, sans séparer le fil lui-même de la plaque. Sans traitement thermique d'une plaque d'alumine métallisée similaire, c'est-à-dire directement après les deux premières étapes du procédé, la force de traction qui est nécessaire pour séparer le fil et la plaque est de l'ordre de 30 mégapascals.

Il doit être entendu que la présente invention n'est en aucune façon limitée aux formes de réalisation ci-dessus et que bien des modifications peuvent y être apportées sans sortir du cadre du présent brevet.

## Revendications

1. Procédé de métallisation d'une surface d'une pièce d'alumine frittée avec une couche de métal qui est fortement adhérente à ladite surface, ce procédé comprenant l'irradiation de la surface à métalliser avec un faisceau de lumière émis par une source laser excimère et l'immersion de la pièce d'alumine traitée au laser dans un bain contenant du métal autocatalytique pour revêtir au moyen d'un plaquage autocatalytique la surface traitée au laser susdite du métal contenu dans le bain, ce procédé étant caractérisé en ce qu'il comprend le traitement à chaud de la pièce métallisée à une température suffisamment élevée pour induire une diffusion de métal de la couche métallique formée lors de l'immersion dans la pièce d'alumine.

2. Procédé suivant la revendication 1, caractérisé en ce que la source laser utilisée est une source laser excimère procurant une densité d'énergie à la pièce d'alumine irradiée qui est suffisante pour faire fondre les zones irradiées de la surface de ladite pièce.

3. Procédé suivant la revendication 2, caractérisé en ce qu'après une interruption de l'irradiation laser susmentionnée et une solidification des zones superficielles fondues de la pièce susdite, on obtient une fine couche de phase $\gamma$ d'alumine à la surface de la pièce d'alumine frittée irradiée, cette fine couche de phase $\gamma$ ayant une épaisseur au moins égale à 20 nanomètres, au-dessus d'une phase $\alpha$ d'alumine texturée pouvant atteindre une profondeur de 1 micromètre dans la pièce d'alumine.

4. Procédé suivant l'une quelconque des revendications 1 à 3, caractérisé en ce que le bain autocatalytique contient des atomes métalliques utilisables dans une solution autocatalytique.

5. Procédé suivant la revendication 3, caractérisé en ce que les atomes métalliques qui sont déposés par voie autocatalytique sur les zones irradiées de la pièce d'alumine sont choisis dans le groupe comprenant le chrome, le manganèse, le fer, le cobalt, le nickel, le cuivre, l'arsenic et le sélénium.

6. Procédé suivant l'une quelconque des revendications 3 à 5, caractérisé en ce que l'on chauffe la pièce métallisée à une température suffisante pour induire la diffusion de métal dans la phase $\gamma$ d'alumine.

7. Procédé suivant l'une quelconque des revendications 1 à 6, caractérisé en ce qu'il permet d'induire la synthèse d'un composé ternaire comprenant des atomes du métal diffusé, fortement couplés à des atomes d'oxygène et d'aluminium pour former des liaisons ioniques ou covalentes.

## Claims

1. Process for plating the surface of a sintered alumina part with a layer of metal which is strongly adhesive to said surface, this process comprising irradiation of the surface to be plated with a beam of light emitted by an excimer laser source, and immersion of the alumina part treated by the laser in a bath containing an electroless metal for covering, by means of electroless plating, the surface treated by the said laser, with the metal contained in the bath, this process being characterised in that it comprises hot treatment of the plated part to a temperature sufficiently high to induce a diffusion of metal from the metallic layer formed during immersion, into the alumina part.

2. Process according to claim 1, characterised in that the laser source used is an excimer laser source providing an energy density on the irradiated alumina part which is sufficient to cause the irradiated zones of the surface of the said part to melt.

3. Process according to claim 2, characterised in that, after an interruption in the abovementioned laser irradiation, and hardening of the superficial melted zones of the above mentioned part, a fine layer of phase $\gamma$ of alumina is obtained on the surface of the irradiated part of sintered alumina, this fine layer of phase $\gamma$ having a thickness at least equal to 20 nanometers, above a phase $\alpha$ of textured alumina which can reach a depth of 1 micrometer in the alumina part.

4. Process according to any one of claims 1 to 3, characterised in that the electroless bath contains metallic atoms usable in an electroless solution.

5. Process according to claim 3, characterised in that the metallic atoms which are deposited electrolessly on the irradiated zones on the alumina part are selected from the group comprising chromium, manganese, iron, cobalt, nickel, copper, arsenic and selenium.

6. Process according to any one of claims 3 to 5, characterised in that the plated part is heated to temperature sufficient to cause diffusion of the metal in the phase $\gamma$ of alumina.

7. Process according to any one of claims 1 to 6, characterised in that it allows induction of synthesis of a ternary compound comprising atoms of the diffused metal, strongly coupled to atoms of oxygen and aluminium in order to form ionic or covalent links.

## Patentansprüche

1. Verfahren zum Metallisieren einer Oberfläche eines Teils aus gesintertem Aluminiumoxid mit einer stark an der Oberfläche haftenden Metallschicht, wobei dieses Verfahren die Bestrahlung der zu metallisierenden Oberfläche mit einem Lichtstrahl, der durch eine Excimerlaserquelle emittiert wird, und das Tauchen des mit dem Laser behandelten Teils aus Aluminiumoxid in ein Bad aufweist, das autokatalytisches Metall enthält, um mittels autokatalytischen Plattierens die mit dem oben genannten Laser behandelte Oberfläche mit dem in dem Bad enthaltenen Metall zu überziehen,

dadurch gekennzeichnet, daß es die Warmbehandlung des metallisierten Teils bei einer ausreichend hohen Temperatur aufweist, um eine Metalldiffusion der beim Tauchen des Teils aus Aluminiumoxid (im Original: "dans la pièce d'alumine" - in das Tell aus Aluminiumoxid) gebildeten Metallschicht einzuleiten.

2. verfahren nach Anspruch 1,
dadurch gekennzeichnet, daß die benutzte Laserquelle eine Excimerlaserquelle ist, die dem bestrahlten Teil aus Aluminiumoxid eine Energiedichte verschafft, die ausreichend ist, um die bestrahlten Zonen der Oberfläche des Teils zu schmelzen.

3. Verfahren nach Anspruch 2,
dadurch gekennzeichnet, daß nach einer Unterbrechung der oben genannten Laserbestrahlung und einer Verfestigung der geschmolzenen Oberflächenzonen des oben genannten Tells eine feine $\gamma$-Phase-Aluminiumoxidschicht auf der Oberfläche des bestrahlten Teils aus gesintertem Aluminiumoxid, wobei diese feine $\gamma$-Phase-Schicht eine Dicke von mindestens gleich 20 Nanometern aufweist, über einer $\alpha$-Phase texturierten Aluminiumoxids erhalten wird, die eine Tiefe von 1 Mikrometer in dem Teil aus Aluminiumoxid erreichen kann.

4. Verfahren nach einem der Ansprüche 1 bis 3,
dadurch gekennzeichnet, daß das autokatalytische Bad Metallatome enthält, die in einer autokatalytischen Lösung verwendbar sind.

5. Verfahren nach Anspruch 3,
dadurch gekennzeichnet, daß die auf autokatalytischem Wege auf die bestrahlten Zonen des Teils aus Aluminiumoxid abgelagerten Metallatome aus der Gruppe ausgewählt sind, die Chrom, Mangan, Eisen, Kobalt, Nickel, Kupfer, Arsen und Selen aufweist.

6. Verfahren nach einem der Ansprüche 3 bis 5,
dadurch gekennzeichnet, daß das metallisierte Teil bei einer ausreichenden Temperatur erwärmt wird, um die Metalldiffusion in der Aluminuiumoxid-$\gamma$-Phase einzuleiten.

7. Verfahren nach einem der Ansprüche 1 bis 6,
dadurch gekennzeichnet, daß es gestattet, die Synthese einer ternären Verbindung einzuleiten, die Atome des diffundierten Metalls aufweist, die stark an Sauerstoff- und Aluminiumatomen gekoppelt sind, um Ionen- oder Atombindungen zu bilden.